# EUROPÄISCHE PATENTSCHRIFT

(11) **EP 1 808 027 B1**
(45) Veröffentlichungstag und Bekanntmachung des Hinweises auf die Patenterteilung: **19.03.2008**
(21) Anmeldenummer: 05785738.5
(22) Anmeldetag: 10.09.2005
(51) Int. Cl.: H04Q 1/14, G01R 31/04, H04L 12/26

(54) **ANORDNUNG ZUR ÜBERWACHUNG VON PATCHFELDERN AN VERTEILERPUNKTEN IN DATENNETZWERKEN**
ARRANGEMENT FOR MONITORING PATCH FIELDS AT DISTRIBUTION POINTS IN DATA NETWORKS
SYSTEME DE SURVEILLANCE DE CHAMPS DE CONNEXION DE POINTS DE DISTRIBUTION DE RESEAUX DE DONNEES

(30) Priorität: 28.10.2004 DE 102004052502
(43) Veröffentlichungstag der Anmeldung: 18.07.2007
(73) Patentinhaber: Data-Complex GmbH, 38820 Halberstadt (DE)
(72) Erfinder: HORN, Thomas, 38895 Langenstein (DE)
(74) Vertreter: Einsel, Martin
(86) Internationale Anmeldenummer: PCT/EP2005/009749
(87) Internationale Veröffentlichungsnummer: WO 2006/045372

(56) Entgegenhaltungen:
- EP-A- 0 575 100
- WO-A-20/04044599
- DE-B3- 10 244 304
- US-B1- 6 784 802

## Beschreibung

Die Erfindung betrifft eine Anordnung zur Überwachung von Patchfeldern an Verteilerpunkten in Datennetzwerken, mit Patchkabeln die mittels Steckern in Anschlüsse in den Patchfeldern einsteckbar sind, wobei beide Stecker je Patchkabel mit je einem Transponder ausgerüstet sind, mit einer Vorrichtung, die vor oder benachbart zu einem der Patchfelder mit seinen Anschlüssen angeordnet ist, wobei die Vorrichtung mit Readern mit Readerspulen ausgerüstet ist, wobei die Reader in Datenverbindung mit einer Auswertungseinheit stehen.

Datennetzwerke dienen unter anderem dazu, eine größere Zahl an Arbeitsplätzen beziehungsweise die dort arbeitenden Mitarbeiter, also die Nutzer des Datennetzwerkes mit Datenanschlüssen zu versehen. Die Nutzer an den Arbeitsplätzen werden so mit einzelnen Diensten versorgt, beispielsweise mit Datendiensten oder auch Telekommunikationsdiensten. Um dies vorzunehmen, weisen die Datennetzwerke zentrale Verteilerpunkte, meistens Verteilerschränke auf. In den Verteilerschränken sind Patchfelder vorgesehen. Diese Patchfelder besitzen Ports, also Anschlüsse. Von den Ports dieser Patchfelder führen Datenkabel sternförmig zu den Datenanschlüssen an den Arbeitsplätzen.

In den Verteilerschränken oder Verteilerpunkten befinden sich neben den Patchfeldern auch die aktiven Geräte. Diese aktiven Geräte dienen der Verteilung der Daten, der Telefonsignale oder auch sonstiger Anwendungen.

Die Verbindung von den aktiven Geräten zu den Patchfeldern (häufig auch Patchpanels genannt) wird mit Patchkabeln realisiert. Diese Patchkabel besitzen an jedem Ende einen Stecker. Dieser Stecker ist in einen Port oder Anschluss an einem Patchfeld einsteckbar. Die Patchkabel sind flexibel und etwa 0,5 m bis 5 m lang. Bei Kupferkabeln sind die Stecker im Allgemeinen sogenannte RJ45-Stecker, Glasfasern werden mit verschiedenen Steckern konfektioniert.

Um nun einen Arbeitsplatz mit den gewünschten Diensten zu versorgen, beziehungsweise ihm diese Dienste zur Verfügung zu stellen, muss nun entsprechend das aktive Gerät mit dem entsprechenden Port am Patchfeld oder Patchpanel verbunden werden. Benötigt zum Beispiel ein Nutzer einen Telefonanschluss sowie einen Datenanschluss, so werden ihm durch das Verbinden der entsprechenden Ports mit dem aktiven Gerät die Telefonanlage und ein Datenswitch zur Benutzung zur Verfügung gestellt.

Bei Veränderungen der Dienste, bei Umzügen, Versetzungen oder auch sonstigen Reorganisationsmaßnahmen kann es erforderlich werden, Veränderungen dieser Verbindungen an den Verteilern vorzunehmen. In diesem Fall muss "umgepatcht" werden. Es müssen also Patchkabel den nunmehr benötigten Diensten entsprechend umgesteckt werden.

Dadurch entstehen eine Reihe von Problemen. Eine Vielzahl an Patchkabeln verdeckt die einzelnen Patchfelder und sie verflechten sich auch miteinander. Nicht mehr benötigte Verbindungen bleiben teilweise noch gepatcht. Die Übersichtlichkeit bei mittleren und großen Installationen nimmt so zwangsläufig teilweise drastisch ab. Die Folge dieser Probleme sind Fehler und Zeitverluste bei der Ausführung der Umpatchungen. Dies wiederum führt zu einem erhöhten Arbeitszeitaufwand des zuständigen Administrators sowie auch bei den Nutzern, bis durch Nacharbeiten die Dienste auch wirklich zur Verfügung stehen. Nicht auszuschließen sind auch Beschädigungen der Geräte oder auch eine gänzlich unbeabsichtigte Außerbetriebnahme von Diensten durch falsches Patchen.

Bei Unternehmen mit verteilten Niederlassungen wird es darüber hinaus auch wünschenswert, eine Fernüberwachung (Remoteüberwachung) und/oder-steuerung zu haben. Dabei sollen dann zentral von einem Administrator aus die Außenstellen überwacht und gegebenenfalls gesteuert werden.

Anordnungen zur Überwachung von Patchfeldern an Verteilerpunkten in Datennetzwerken sind beispielsweise aus der EP 0 575 100 B1, der US-PS 6,784,802 und der DE 102 44 304 B3 bekannt.

Anordnungen entsprechend der DE 102 44 304 B3 weisen Patchkabel auf, die mittels Steckern in Anschlüsse in den Patchfeldern eingesteckt werden können.

Die Patchkabel sind an ihren beiden Enden jeweils mit einem Stecker ausgerüstet. Jeder Stecker ist mit einem Transponder versehen.

Die Anschlüsse in den Patchfeldern sind dabei jeweils mit einer Readerspule mit einem Reader ausgerüstet und diese Reader stehen in Datenverbindung mit einer Auswertungseinheit.

Mit derartigen Anordnungen können Patchfelder in Telefonanlagen, Sicherheitsanlagen, Überwachungseinrichtungen, Switches, Hubs, und andere aktive Geräte sowie auch passive Systeme wie Verteilerfelder (Patchpanels) im Glasfaser- und Kupferbereich entsprechend betreut werden.

Diese Panels und Geräte stammen von unterschiedlichsten Herstellern und können auch sehr unterschiedlich aufgebaut werden. Beim Nachrüsten von Readerspulen für bereits vorhandene Patchfelder muss daher mechanisch jedes Patchfeld mit einem Reader und jeder Anschluss eines Patchfeldes mit einer Readerspule versehen werden. In einer Ausführungsform wird in der DE 102 44 304 B3 auch schon vorgeschlagen, die Readerspulen in Blenden anzuordnen und dann diese Blenden jeweils nachträglich an den Patchfeldern anzubringen. In diesem Falle ist für jedes unterschiedliche Gerät zunächst die Fertigung einer derartigen Blende erforderlich.

Trotz der technisch bereits sehr praktikablen und zuverlässigen Anordnungen nach der DE 102 44 304 B3 besteht daher der Wunsch, noch weniger aufwendigere Anordnungen vornehmen zu können.

Eine Aufgabe der Erfindung ist es, eine gattungsgemäße Anordnung vorzuschlagen, die mit weniger Aufwand herzustellen ist.

Diese Aufgabe wird bei einer gattungsgemäßen Anordnung dadurch gelöst, dass die Vorrichtung mit einer Vielzahl von Readerspulen versehen ist, die die Zahl der Anschlüsse in dem Patchfeld übersteigt, und dass die Readerspulen jeweils unabhängig von den anderen Readerspulen durch eine Readerelektronik, die einen oder mehrere Reader aufweist, ansteuerbar ist.

Die Reader werden damit jetzt nicht mehr einem einzelnen Anschluss oder Port in dem Patchfeld konkret zugeordnet beziehungsweise in dessen Nähe angebracht. Stattdessen werden die Reader in der zusätzlichen Vorrichtung angeordnet. Diese Vorrichtung trägt nun eine Vielzahl von Readerspulen, die die Zahl der Ports deutlich übersteigen kann. Es werden also mehr Readerspulen auf dieser Vorrichtung angeordnet, als eigentlich für den Zweck erforderlich sind. Sie können also wesentlich dichter zueinander angebracht werden.

Da die Leseelemente jeweils eine Richtcharakteristik besitzen, kann das magnetische Feld, das diese Spulen aufbauen, direkt auf eine Position gerichtet werden, an der sich ein Transponder befindet beziehungsweise befinden kann. Das sind Positionen, die jeweils einem Anschluss oder Port entsprechen, denn dort soll ja ein Stecker eingesteckt werden, der einen solchen Transponder trägt.

Die Richtcharakteristik kann also verwendet werden, um genau diese Positionen anzusprechen und nur denjenigen Transponder auszulesen, der sich an oder in einem Stecker befindet, der sich genau gegenüber oder jedenfalls nahe der entsprechenden Spule des Readers befindet.

Aufgrund der Vielzahl an vorgesehenen Readerspulen befindet sich jeweils mindestens eine Spule eines Readers über oder nahe einem Port. Diese richtig oder wünschenswert positionierte Readerspule kann durch eine Elektronik angesteuert werden, um die Richtcharakteristik auszunutzen. Das korrekte Ausrichten wird damit von dem mechanischen Anordnen einer Readerspule auf einem Patchfeld beziehungsweise benachbart zu einem Port getrennt und in die Elektronik verlegt, die die mit einer Richtcharakteristik versehenen Readerspulen ansteuert.

Eine größere Zahl von vorhandenen Spulen bleibt dabei ungenutzt. Diese Spulen oder Reader stören jedoch die Funktionsfähigkeit der gesamten Anordnung nicht.

Es kann jetzt also für eine große Zahl möglicher Patchfelder jeweils ein und dieselbe Vorrichtung mit darauf angeordneten Readerspulen verwendet werden. Diese Vorrichtung kann dann beispielsweise nach Art einer Blende benachbart zum Patchfeld montiert werden und wird dann durch die Elektronik so gesteuert, dass genau eine Readerspule auf eine Position gerichtet wird, auf der sich ein Transponder befinden kann. Die Readerelektronik kann dann zum einen feststellen, ob sich nun tatsächlich ein Transponder dort befindet, also ob dort überhaupt ein Stecker eingesteckt ist, und zum anderen kann der tatsächlich dort eingesteckte Transponder auch ausgelesen werden.

Die Elektronik wird dann jeweils für einen Typ eines Patchfeldes eingestellt. Dies ist natürlich deutlich weniger aufwendig, als jeweils unterschiedliche Anordnungen von Readerspulen zu entwerfen oder diese jeweils einzeln anzubringen. Die dadurch mögliche Massen- und Serienfertigung von einheitlichen Vorrichtungen mit Readern und Readerspulen ist wesentlich kostengünstiger als der Mehraufwand, der durch die im konkreten Einzelfall nicht benötigten Readerspulen entsteht.

Die Vorrichtung ist bevorzugt plattenförmig und trägt dann auf einer Plattenseite die Readerspulen.

In einer weiter bevorzugten Ausführungsform wird die plattenförmige Vorrichtung auf beiden Seiten mit Readerspulen ausgerüstet. Sie kann dann beispielsweise zwischen zwei Patchfeldern angebracht werden und dann die sich oberhalb beziehungsweise unterhalb der Vorrichtung befindenden Transponder auslesen.

Die gesamte Anordnung und Funktionsweise im übrigen kann gegenüber einer Konzeption aus der DE 102 44 304 B3 unverändert bleiben. So stehen wiederum die Reader in einer Datenverbindung mit einer Auswertungseinheit, die auch mit der Elektronik kombiniert sein kann, die die einzelnen Readerspulen steuert.

Die insbesondere plattenförmige Vorrichtung wird etwa nach Art einer Blende montiert. Dabei ist unter Blende nicht zu verstehen, dass die Vorrichtung das Patchfeld abdeckt, denn die Stecker werden nicht durch diese Vorrichtung hindurch gesteckt, sondern befinden sich lediglich benachbart zu der blendenähnlichen Vorrichtung. Die Vorrichtung erkennt die Transponder an den jeweiligen Steckern und liest die in den Transpondern enthaltenen Daten aus oder beschreibt diese in umgekehrter Richtung und informiert jeweils die Auswertungseinheit, die auch als Master bezeichnet werden kann.

Zur besseren optischen Erkennung ist es bevorzugt, dass jede Readerspule der Vorrichtung mit einer optischen Anzeige versehen ist, vorzugsweise mit einer Licht emittierenden Diode (LED). Durch eine solche Signalisierung mittels eines Leuchtmittels an der Vorrichtung können dem Anwender Informationen mitgeteilt werden. So können ihm mit Hilfe dieser optischen Anzeigen die möglicherweise zweckmäßigen Aktionen mitgeteilt werden, beispielsweise eine Anzeige der Verbindungen, die geändert werden sollten. Auch Fehler können so signalisiert werden. Die Auswertungseinheit oder eine andere Elektronik steuert auch diese optischen Anzeigen oder Leuchtmittel.

Einem Teil der Elektronik oder Auswertungseinheit, beispielsweise einer Kontrolleinheit an der Blende, kann auch bekannt sein, ob und welchen Typ eines Patchfeldes oder Gerätes sie steuert. Mit Hilfe dieser Information kann sie dann automatisch die Readerspulen ansteuern und zwar in ausgebildeter Form genau diejenigen, die jeweils einem Port oder Anschluss gegenüber oder am nächsten stehen. Die nicht benötigten Readerspulen werden nicht genutzt und in geeigneter Form außer Betrieb gehalten.

Die erfindungsgemäße Anordnung ermöglicht es, ein und die gleiche Vorrichtung nach Art einer Universalblende für die unterschiedlichsten Varianten von Paneln und Geräten mit Patchfeldern einzusetzen, also nur einen Typ einer solchen Vorrichtung zu fertigen und damit die verschiedensten Anordnungen aufbauen zu können und die unterschiedlichsten Geräte steuern zu können.

Ein weiterer Vorteil besteht auch darin, dass durch die hochpräzise Möglichkeit der Vorfertigung auch solche Patchfelder bearbeitet werden können, bei der Stecker in sehr nahe beieinander liegenden Ports eingesteckt werden müssen, so dass auch die entsprechenden Transponder in den Steckern sehr nahe beieinander liegen.

Im Folgenden werden drei Ausführungsbeispiele der Erfindung im Einzelnen beschrieben.

Es zeigen:
- **Figur 1**: eine schematische Darstellung einer ersten Ausführungsform einer erfindungsgemäßen Anordnung;
- **Figur 2**: eine schematische Darstellung einer zweiten Ausführungsform einer erfindungsgemäßen Anordnung; und
- **Figur 3**: eine perspektivisch andere schematische Darstellung der ersten Ausführungsform einer erfindungsgemäßen Anordnung.

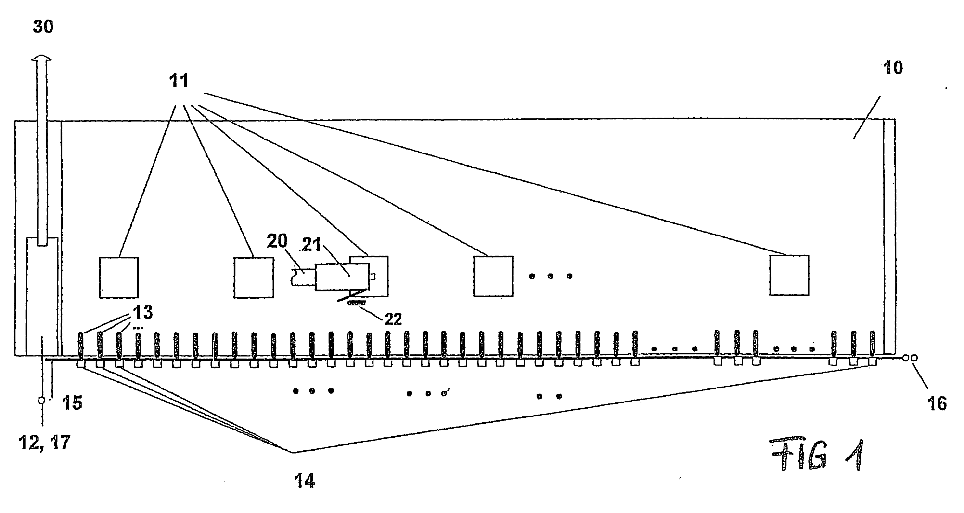

In der **Figur 1** ist ein bevorzugtes Ausführungsbeispiel einer derartigen erfindungsgemäßen Anordnung schematisch dargestellt. Zu erkennen ist ein Patchfeld 10 mit einer Vielzahl von Anschlüssen 11, den so genannten Ports. In der Figur 1 sind fünf davon zu erkennen. Diese Anschlüsse 11 ermöglichen das Einstecken von Patchkabeln 20 beziehungsweise von Steckern 21, die sich am Ende eines solchen Patchkabels 20 befinden. In der Figur 1 ist aus Vereinfachungsgründen nur ein Patchkabel 20 mit einem Stecker 21 angedeutet, der in einen der Anschlüsse 11 eingesteckt ist.

Die Patchkabel 20 dienen dazu, mehrere Patchfelder 10 miteinander beziehungsweise mit bestimmten Dienstleistungsgeräten, etwa Telefonanschlüssen zu versorgen. Ein Patchkabel 20 hat zwei Enden, die jeweils mit einem Stecker 21 ausgerüstet sind. In dem Stecker 21 oder bei nachträglicher Ausrüstung an dem Stecker 21 des Patchkabels 20 befindet sich der Transponder 22.

Der Transponder 22 besitzt ebenfalls eine Spule sowie eine elektronische Schaltung, ist aber insgesamt sehr klein gehalten und findet an oder im Stecker 21 problemlos Platz. Bei origineller Herstellung würde der Transponder 22 von vornherein mit dem Stecker 21 beziehungsweise im Kunststoff um den Stecker 21 eingespritzt werden, bei einer Nachrüstung bei bereits vorhandenen Patchkabeln 20 mit Steckern 21 ist aber auch ein problemloses Anbringen außen möglich.

In der Darstellung in der Figur 1 ist das Patchfeld 10 etwa in der Blattebene. Senkrecht zur Blattebene befindet sich eine Vorrichtung 15, die mittels einer mechanischen Arretierung 16 benachbart zum Patchfeld 10 arretiert ist. Dies Vorrichtung 15 ist plattenförmig, so dass sie sich in der Zeichnung als Linie abbildet.

Auf der Vorrichtung 15 befinden sich Reader 12 mit Readerspulen 13. Diese sind hier in regelmäßiger und in gleichem Abstand befindlicher Anordnung dargestellt.

Dies ermöglicht es nun, dass einem bestimmten Anschluss 11 genau eine Readerspule 13 zugeordnet wird. Die Readerspule 13 mit einer Richtcharakteristik ist genau auf den Anschluss 11 beziehungsweise eine Position in dessen Nähe ausgerichtet, wie im folgenden erörtert wird.

Befindet sich nämlich nun ein Stecker 21 mit einem daran oder darin befestigten Transponder 22 in demjenigen Anschluss 11, auf den die Readerspule 13 ausgerichtet ist, kann nun mittels einer Readerelektronik 17 die auf dem Transponder 22 befindliche Information ausgelesen werden.

Die Auswertung der Readerelektronik 17 erfolgt durch Weitergabe dieser Informationen an eine Auswertungseinheit 30, beispielsweise ein elektronisches Gerät und eine dazu gehörige Software, gegebenenfalls unter Zwischenschaltung eines Mikrocontrollers.

Die Auswertungseinheit 30 kann an einem anderen, gegebenenfalls auch weit entfernten Ort stehen, um eine Fernüberwachung zu ermöglichen.

Jeder Readerspule 13 ist in der Darstellung eine optische Anzeige 14 zugeordnet, beispielsweise eine Licht emittierende Diode (LED), die zur Signalisierung von Fehlern oder anderen Auswertungen dient.

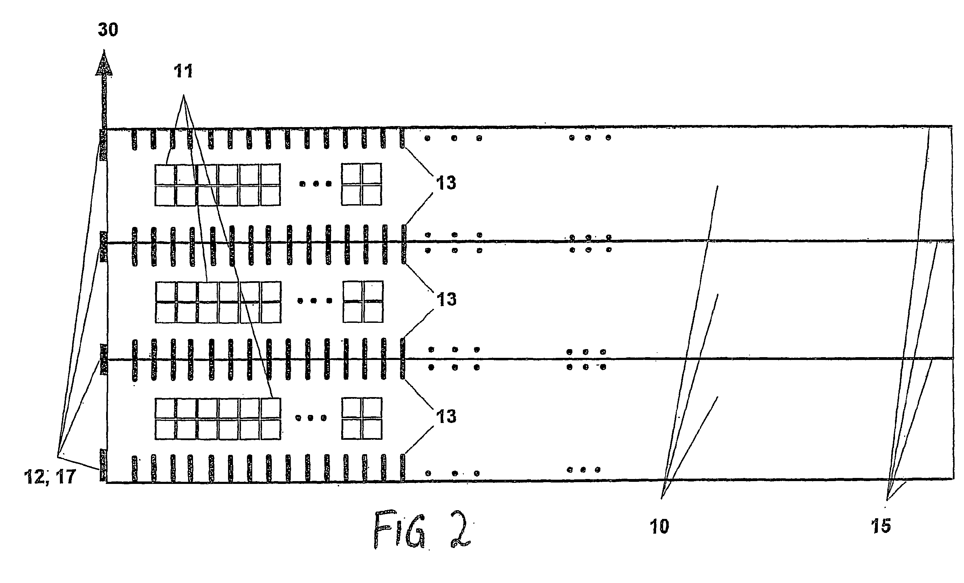

In der **Figur 2** ist schematisch dargestellt, dass eine Vorrichtung 15 auch auf beiden Seiten mit Readern 12 und Readerspulen 13 versehen sein kann, um insbesondere auch Anschlüsse 11 bequem bedienen zu können, die sich in Reihen übereinander oder nebeneinander befinden. Die Figur 2 zeigt dabei auch, dass mehrere derartige Vorrichtungen 15 für ein Patchfeld 10 eingesetzt werden können, wenn dieses aufgrund der Größe des Patchfeldes 10 sinnvoll oder erforderlich scheint.

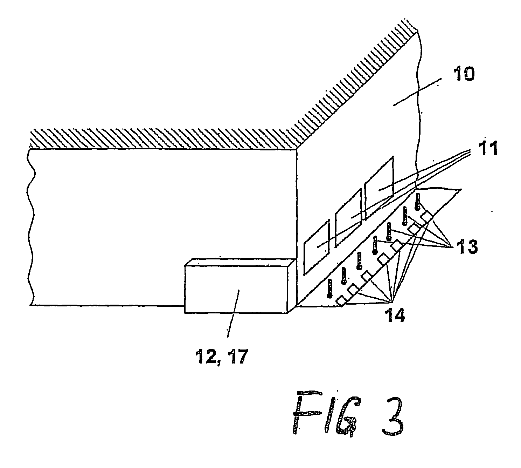

In der **Figur 3** ist in einer schematischen perspektivischen Ansicht angedeutet, wie sich eine Anordnung für den Benutzer darstellt. Man sieht ein Gerät, das in der Darstellung etwa kastenförmig ist. Auf seiner nach rechts weisenden Seite befindet sich ein Patchfeld 10 mit Anschlüssen 11. Senkrecht zu der Seite mit dem Patchfeld 10 wird eine plattenförmige Vorrichtung 15 angeordnet. Auf der Vorrichtung 15 befinden sich hier auf der Oberseite Readerspulen 13 mit einer Richtcharakteristik. Die Steuerelektronik 17 mit mindestens einem Reader 12 ermöglicht es, jede einzelne Readerspule 13 anzusprechen und bestimmten Anschlüssen 11 am nächsten liegende Readerspulen 13 anzusteuern.

Auch hier sieht man die optischen Anzeigen 14, die jeweils den einzelnen Readerspule 13 zugeordnet sind und Lichtsignale abgeben können.

### Bezugszeichenliste

- 10: Patchfeld
- 11: Anschluss oder Port
- 12: Reader
- 13: Readerspule
- 14: optische Anzeige
- 15: Vorrichtung
- 16: mechanische Arretierung
- 17: Readerelektronik

- 20: Patchkabel
- 21: Stecker des Patchkabels
- 22: Transponder an oder im Stecker

- 30: Auswertungseinheit

## Patentansprüche

1. Anordnung zur Überwachung von Patchfeldern (10) an Verteilerpunkten in Datennetzwerken,
mit Patchkabeln (20) die mittels Steckern (21) in Anschlüsse (11) in den Patchfeldern (10) einsteckbar sind,
wobei beide Stecker (21) je Patchkabel (20) mit je einem Transponder (22) ausgerüstet sind,
mit einer Vorrichtung (15), die vor oder benachbart zu einem der Patchfelder (10) mit seinen Anschlüssen (11) angeordnet ist,
wobei die Vorrichtung (15) mit Readern (12) mit Readerspulen (13) ausgerüstet ist,
wobei die Reader (12) in Datenverbindung mit einer Auswertungseinheit (30) stehen,
**dadurch gekennzeichnet,**
**dass** die Vorrichtung (15) mit einer Vielzahl von Readerspulen (13) versehen ist, die die Zahl der Anschlüsse (11) in dem Patchfeld (10) übersteigt, und
**dass** die Readerspulen (13) jeweils unabhängig von den anderen Readerspulen (13) durch eine Readerelektronik (17), die einen oder mehrere Reader (12) aufweist, ansteuerbar sind.

2. Anordnung nach Anspruch 1,
**dadurch gekennzeichnet,**
**dass** jede Readerspule (13) der Vorrichtung (15) mit einer optischen Anzeige für zugehörige Anschlüsse (11) versehen ist, vorzugsweise mit Licht emittierenden Dioden (LED) (14).

3. Anordnung nach Anspruch 1 oder 2,
**dadurch gekennzeichnet,**
**dass** die Vorrichtung (15) plattenförmig ist und ähnlich einer Blende an oder benachbart zu den Patchfeldern (10) angebracht ist.

4. Anordnung nach Anspruch 3,
**dadurch gekennzeichnet,**
**dass** die plattenförmige Vorrichtung (15) auf beiden Plattenseiten mit Readerspulen (13) ausgerüstet werden kann oder ausrüstbar ist.

## Claims

1. Arrangement for monitoring patch panels (10) at distribution points in data networks, with patch cables (20) which can be plugged by means of plugs (21) into connections (11) in the patch panels (10), each of the two plugs (21) of each patch cable (20) being equipped with a transponder (22), with a device (15), which is arranged in front of or adjacent to one of the patch panels (10) with its connections (11), the device (15) being equipped with readers (12) with reader coils (13), the readers (12) being in data connection with an evaluation unit (30), **characterised in that** the device (15) is provided with a multiplicity of reader coils (13), which exceeds the number of connections (11) in the patch panel (10) and **in that** the reader coils (13), independently of the other reader coils (13) in each case, can be controlled by reader electronics (17) having one or more readers (12).

2. Arrangement according to claim 1, **characterised in that** each reader coil (13) of the device (15) is provided with an optical display for associated connections (11), preferably with light-emitting diodes (LEDs) (14).

3. Arrangement according to claim 1 or 2, **characterised in that** the device (15) is in the form of a plate and is provided, similarly to a screen, on or adjacent to the patch panels (10).

4. Arrangement according to claim 3, **characterised in that** the plate-like device (15) can be equipped, or can be equipped, on both plate sides with reader coils (13).

## Revendications

1. Dispositif de surveillance de zones de connexion (10) au niveau de points de distribution de réseaux de données,
avec des cordons de raccordement (20) pouvant être insérés à l'aide de connecteurs (21) dans des branchements (11) des zones de connexion (10),
les deux connecteurs (21) par cordon de raccordement (20) étant respectivement munis d'un transpondeur (22),
avec un dispositif (15), lequel est disposé devant ou à proximité de l'une des zones de connexion (10) avec ses branchements (11),
le dispositif (15) étant muni de lecteurs (12) avec des bobines de lecture (13),
les lecteurs (12) étant en liaison de données avec une unité d'analyse (30),
**caractérisé en ce que**
le dispositif (15) est muni d'une pluralité de bobines de lecture (13), dont le nombre est supérieur au nombre de branchements (11) dans la zone de connexion (10), et
**en ce que** les bobines de lecture (13) peuvent être commandées respectivement de manière indépendante des autres bobines de lecture (13) grâce à un équipement électronique de lecture (17), lequel présente un ou plusieurs lecteurs (12).

2. Dispositif selon la revendication 1, **caractérisé en ce que**
chaque bobine de lecture (13) du dispositif (15) est munie d'une signalisation optique pour des branchements (11) associés, de préférence avec des diodes électroluminescentes (LED)(14).

3. Dispositif selon la revendication 1 ou 2, **caractérisé en ce que**
le dispositif (15) est en forme de plaque et est fixé à la manière d'un écran sur, ou au voisinage, des zones de connexion (10).

4. Dispositif selon la revendication 3, **caractérisé en ce que**
le dispositif en forme de plaque (15) peut être équipé ou est muni, des deux côtés de la plaque, avec des bobines de lecture (13).
